(19) Europäisches Patentamt
European Patent Office
Office européen des brevets

(11) **EP 2 446 281 B1**

(12) **FASCICULE DE BREVET EUROPEEN**

(45) Date de publication et mention de la délivrance du brevet:
**13.06.2018 Bulletin 2018/24**

(21) Numéro de dépôt: **10734518.3**

(22) Date de dépôt: **21.06.2010**

(51) Int Cl.:
*G01R 22/06* (2006.01)   *G01R 11/25* (2006.01)
*G01R 21/133* (2006.01)

(86) Numéro de dépôt international:
**PCT/FR2010/051259**

(87) Numéro de publication internationale:
**WO 2010/149921 (29.12.2010 Gazette 2010/52)**

(54) **COMPTEUR D'ENERGIE ELECTRIQUE A CAPTEUR DE COURANT NON ISOLE ET CONTACTEUR DE COUPURE**

STROMZÄHLER MIT UNISOLIERTEM STROMSENSOR UND SPERRSCHÜTZ

ELECTRICITY METER HAVING AN UNINSULATED CURRENT SENSOR AND A CUTOFF CONTACTOR

(84) Etats contractants désignés:
**AL AT BE BG CH CY CZ DE DK EE ES FI GB GR HR HU IE IS IT LI LT LU LV MC MK MT NL NO PL PT RO SE SI SK SM TR**

(30) Priorité: **22.06.2009 FR 0954218**

(43) Date de publication de la demande:
**02.05.2012 Bulletin 2012/18**

(73) Titulaire: **Itron Global SARL**
**Liberty Lake WA 99019 (US)**

(72) Inventeurs:
• **AUFFRET, Yves**
**F-86000 Poitiers (FR)**
• **LAGAUTRIERE, Jean-Loup**
**F-86340 Nouaille Maupertuis (FR)**
• **CHARTOUNI, Patrick**
**F-86580 Vouneuil Sous Biard (FR)**

(74) Mandataire: **Howson, Richard Giles Bentham**
**Kilburn & Strode LLP**
**Lacon London**
**84 Theobalds Road**
**London WC1X 8NL (GB)**

(56) Documents cités:
**GB-A- 2 281 401        GB-A- 2 313 201**
**US-A1- 2008 204 953**

**Description**

La présente invention concerne un compteur électrique équipé d'un dispositif de surveillance des différences de potentiel entre un premier potentiel donné par un conducteur de phase et un second potentiel du compteur.

L'invention est applicable à un compteur électrique de type monophasé, comportant un seul conducteur de phase et un conducteur de neutre donnant le second potentiel.

L'invention est également applicable à un compteur électrique polyphasé, comportant n conducteurs de phases, par exemple trois phases, et un conducteur de neutre donnant le second potentiel.

L'invention est enfin applicable à un compteur électrique polyphasé sans conducteur neutre. Dans ce cas, le second potentiel est interne au compteur.

Les fournisseurs d'énergie électrique requièrent depuis peu que les compteurs électriques soient associés à un contacteur de coupure d'alimentation du courant de phase, de préférence placé dans l'enceinte métrologique des compteurs, de manière à pouvoir commander à distance ce contacteur par l'intermédiaire du compteur. Un distributeur peut ainsi, sans nécessiter le déplacement de personnel de maintenance, interrompre ou rétablir la distribution d'énergie à un utilisateur. Cela permet notamment de gérer le cas de l'utilisateur qui n'a pas payé sa facture d'électricité, ou alors le cas de la résiliation de l'abonnement d'un locataire jusqu'à l'arrivée d'un nouveau locataire.

Ce contacteur de coupure est généralement placé en série dans chaque phase n du réseau de distribution, le conducteur de neutre n'étant par conséquent pas coupé par ce contacteur. Lorsqu'une commande d'ouverture est effectuée, le compteur d'électricité doit surveiller les différences de potentiel entre la phase du réseau et le second potentiel, donné par exemple par le conducteur de neutre lorsque celui-ci est prévu, en amont et en aval du pôle ouvert du contacteur.

Plus précisément, lorsque le contacteur de coupure a été ouvert, il est nécessaire de pouvoir mesurer la quantité suivante :

$$V_{aval-amont}^{phn} = V_{amont}^{phn} - V_{aval}^{phn}$$

relation dans laquelle, pour une phase n donnée, $V_{amont}^{phn}$ correspond à la différence de potentiel entre le conducteur de neutre et la phase n coté réseau de distribution (en amont du compteur), et $V_{aval}^{phn}$ correspond à la différence de potentiel entre le conducteur de neutre et la phase coté charge (en aval du compteur et du contacteur de coupure).

L'objectif de cette surveillance est de pouvoir détecter différentes situations qui font suite à l'ouverture du contacteur de coupure, et de pouvoir réagir en conséquence à ces situations.

Une première situation possible concerne la fraude de l'utilisateur par court-circuit du contacteur de coupure, de façon à pouvoir dériver un courant du réseau de distribution qui sera non mesuré par le compteur.

Une autre situation concerne la présence d'une source d'auto production en aval du contacteur de coupure, par exemple un groupe électrogène que l'utilisateur aurait installé suite à une coupure de distribution par ouverture du contacteur de coupure. Dans une telle situation, toute commande de fermeture du contacteur de coupure risquerait d'établir un court-circuit et une dégradation des éléments tels que le compteur et la source d'auto production. Ainsi, avant de valider toute commande de ré-enclenchement du contacteur de coupure par le compteur, il est impératif de s'assurer au préalable qu'aucune source d'auto production n'est présente.

Une autre situation concerne l'exigence supplémentaire selon laquelle un ordre de ré-enclenchement du contacteur de coupure ne doit être validé que suite à une action volontaire de l'utilisateur sur le disjoncteur principal. Dans ce cas, avant que le compteur commande effectivement la fermeture du contacteur de coupure, il doit au préalable détecter le ré-enclenchement manuel du disjoncteur principal.

Par ailleurs, la surveillance de la quantité $V_{aval-amont}^{phn}$ peut être nécessaire également dans le cas où le contacteur de coupure est en position fermée, afin de détecter une élévation anormale de la résistance de contact du contacteur de coupure due à une dégradation de l'état de surface des pôles du contacteur, élévation qui pourrait mettre en danger l'intégrité du compteur et de l'installation électrique par un échauffement excessif de ces pôles.

Certains compteurs connus utilisent un capteur de courant isolé associé à une électronique de traitement dont le potentiel de référence est le neutre du réseau. C'est le cas notamment des compteurs dans lesquels les capteurs de courant utilisés sont des transformateurs de courant, ou des capteurs inductifs, ou des capteurs actifs de type à effet Hall ou capteurs de champ magnétique.

Pour ce type de compteurs, les tensions $V_{aval}^{phn}$ et $V_{amont}^{phn}$ sont alors mesurées via deux ponts résistifs placés respectivement d'une part, entre le conducteur de phase et le conducteur de neutre en amont du contacteur de coupure et, d'autre part, entre le conducteur de phase et le conducteur de neutre en aval du contacteur de coupure. Chacun de ces deux ponts résistifs délivre des signaux référencés au potentiel du neutre, et atténue ces tensions entre phase et neutre à des amplitudes compatibles avec les niveaux d'entrée des convertisseurs analogique-numérique.

Les détections de fraude par court circuit du shunt et du contacteur et de présence d'une auto production en aval du contacteur sont facilement réalisées par comparaisons des amplitudes et phases des deux mesures de tension en amont et en aval.

Pour détecter la manoeuvre du disjoncteur principal par un utilisateur, une résistance de forte valeur est ajoutée en parallèle sur le contact de puissance du contacteur de manière à générer une différence de potentiel aux bornes du pont résistif mesurant la tension aval, cette tension étant fortement influencée par l'impédance équivalente de la charge aval notamment une charge de très forte valeur lorsque les pôles (uni ou bipolaire) du disjoncteur sont ouverts ou de valeur ohmique plus faible lorsque ce disjoncteur est refermé sur une charge aval résiduelle.

Il n'existe cependant aucune solution à ce jour permettant une surveillance équivalente pour les compteurs électriques utilisant un capteur de courant non isolé, par exemple un capteur résistif de type shunt. Or, un tel capteur présente des avantages en termes d'immunité à la fraude par usage d'un aimant permanent, et est également peu sensible aux champs magnétiques alternatifs.

GB 2281401 concerne un compteur électrique destiné à mesurer l'énergie électrique fournie à une charge, l'appareil de mesure comportant un interrupteur pour interrompre l'alimentation de la charge comprend: des moyens pour générer un signal d'indiquer si l'interrupteur est ouvert; et des moyens logique pour générer un signal d'alerte si la chute de tension entre les bornes d'alimentation est inférieure à une valeur de seuil alors que l'interrupteur est ouvert.

US 2008/0204953 concerne un procédé de détection de la présence d'une condition dangereuse de la ligne à un dispositif d'alimentation de dosage. Le procédé comprend les étapes consistant à déterminer si un commutateur de déconnexion se trouve dans la position ouverte, et à mesurer une première tension à un premier contact de charge. Le procédé mesure une seconde tension à un deuxième contact de charge et détermine si la première tension est supérieure à un premier seuil de tension ou inférieure à un second seuil de tension.

GB 2313201 concerne un dispositif pour mesurer la pression ou la différence de potentiel (Vin - Vout) à travers des moyens pour isoler situé dans une ligne d'alimentation. Le dispositif détecte si la pression ou la différence de potentiel (Vin - Vout) est en dessous d'une valeur prédéterminée lorsque le moyen de sectionnement est en fonctionnement.

La présente invention a pour but de pallier les limitations précédentes en proposant un dispositif de surveillance des différences de potentiel entre un premier potentiel donné par un conducteur de phase et un second potentiel dans un compteur électrique à usage résidentiel à capteur de courant non isolé disposant d'un contacteur de coupure sur chacune des phases du compteur.

Plus précisément, l'invention a pour objet un compteur d'énergie électrique selon la revendication 1. Un compteur d'énergie électrique pour la mesure d'un courant de phase $I_{phn}$ et d'une tension de phase $U_{phn}$ consommés par une installation utilisateur sur au moins une phase n d'un réseau de distribution électrique, le compteur étant du type comportant une partie métrologique dont la référence de potentiel est constituée par ladite phase n, ladite partie métrologique comprenant un capteur de courant non isolé en série sur le conducteur de phase n pour permettre la mesure du courant de phase $I_{phn}$ à partir d'une mesure de la différence de potentiel $V_{mes}$ aux bornes dudit capteur un contacteur de coupure en série avec ledit capteur de courant et un dispositif de surveillance apte à délivrer une mesure $V_{aval-amont}^{phn}$ représentative de la différence de potentiel entre le conducteur de phase en aval du contacteur de coupure et le conducteur de phase en amont de la partie métrologique,
caractérisé en ce que la partie métrologique comporte en outre un premier diviseur de tension recevant en entrée ladite tension de phase $U_{phn}$ et délivrant une mesure d'une différence de potentiel $V_{amont}^{phn}$ entre un premier potentiel donné par le conducteur de phase et un second potentiel, en ce que le dispositif de surveillance comprend un deuxième diviseur de tension connecté en parallèle sur l'ensemble série formé par le capteur de courant et le contacteur de coupure, et une résistance placée entre le conducteur de phase et le second potentiel en aval du contacteur de coupure, et en ce que, l'installation utilisateur comportant un disjoncteur principal, le compteur comporte des moyens pour détecter, lorsque le contacteur de coupure et le disjoncteur principal sont en position ouvertes, la transition de la mesure $V_{aval-amont}^{phn}$ entre une première valeur égale à $a1 \times V_{amont}^{phn}$ et une deuxième valeur égale à $a2 \times V_{amont}^{phn}$, représentatives respectivement d'une transition de position du disjoncteur principal d'un état fermé à un état ouvert et d'une transition de position du disjoncteur principal d'un état ouvert à un état fermé.

Le compteur peut alors avantageusement comporter des moyens pour autoriser une demande de fermeture du contacteur de coupure lorsque ladite transition a été détectée, et des moyens pour refuser une demande de fermeture du contacteur de coupure sinon.

Dans un mode de réalisation particulier, le second potentiel est donné par un conducteur de neutre.

En variante, le second potentiel est interne au compteur.

Dans une réalisation préférée, le compteur comporte, lorsque le contacteur de coupure est en position fermée, des moyens de calcul d'un coefficient représentatif des pertes actives dans le contacteur de coupure et le capteur de courant à partir de mesures de la différence de potentiel $V_{mes}$ aux bornes dudit capteur et de mesures $V_{aval-amont}^{phn}$ représentatives de la différence de potentiel entre le conducteur de phase en aval du contacteur de coupure et le conducteur de phase en amont de la partie métrologique, et des moyens de surveillance de la dérive dudit coefficient par rapport à un seuil prédéterminé, pour détecter une élévation anormale de la résistance de contact du contacteur de coupure.

Des moyens commandent alors avantageusement l'ouverture du contacteur de coupure si la dérive dudit coefficient dépasse ledit seuil prédéterminé.

Le compteur comporte de préférence, lorsque le contacteur de coupure est en position ouverte, des moyens de surveillance pour surveiller si la mesure $V_{aval-amont}^{phn}$ passe en-deçà d'un seuil bas correspondant à un pourcentage de la mesure $V_{amont}^{phn}$, et le cas échéant, des moyens pour générer une alerte à la fraude.

Le compteur comporte également, de préférence, lorsque le contacteur de coupure est en position ouverte, des moyens de calcul d'un signal de tension représentatif d'une source d'auto production an aval du contacteur de coupure à partir des mesures $V_{amont}^{phn}$ et $V_{aval-amont}^{phn}$, des moyens de surveillance pour surveiller si la phase dudit signal de tension est différente de la phase de V1, et si l'amplitude dudit signal de tension dépasse un pourcentage donné de l'amplitude du signal d'entrée du réseau de distribution, typiquement 70% de V1, et, le cas échéant, des moyens pour refuser une demande de fermeture du contacteur de coupure.

L'invention sera mieux comprise au vu de la description suivante faite en référence aux figures annexées, dans lesquelles :

- la figure 1 représente sous forme de schéma électrique la connexion de la partie métrologique d'un compteur électrique équipé du dispositif de surveillance conforme pour une phase n d'un compteur électrique ;
- la figure 2 représente le schéma électrique équivalent dans le cas d'une fraude par court-circuit du contacteur de coupure ;
- la figure 3 représente le schéma électrique équivalent dans le cas de la présence d'une source d'auto production en aval du contacteur de coupure ;
- la figure 4 résume, sous forme de synoptique simplifié, les traitements de signaux effectués par le compteur d'énergie électrique conforme à l'invention pour les différentes détections.

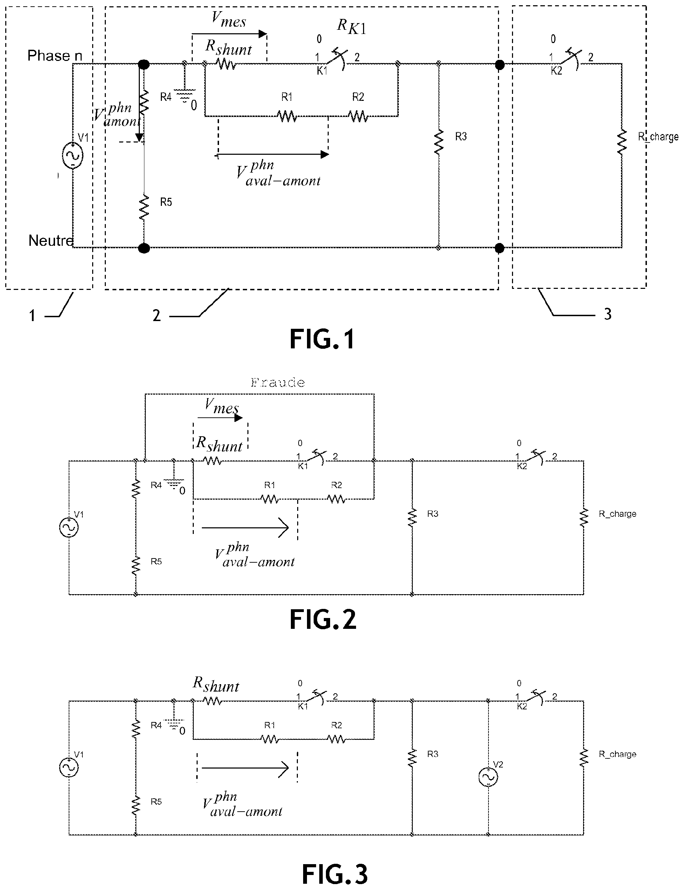

La figure 1 représente sous forme de trois blocs fonctionnels, la connexion d'une phase n d'un compteur électrique à capteur de courant non isolé dans un réseau de distribution électrique. Plus précisément, le bloc 1 représente le réseau de distribution électrique pour la phase n, le bloc 2 représente la partie métrologique du compteur électrique apte à effectuer les mesures de courant et de tension sur la phase n du réseau, et le bloc 3 représente la charge en aval de cette partie métrologique, à savoir l'installation électrique de l'utilisateur.

Le réseau de distribution électrique du bloc 1 est équivalent à une source de puissance délivrant une tension $U_{phn}$ entre le conducteur de phase n et le conducteur de neutre ainsi qu'un courant de phase $I_{phn}$. Sur la figure 1, la tension $U_{phn}$ est représentée par -V1.

La charge 3 en aval de la partie métrologique 2 du compteur est composée d'un disjoncteur K2 qui est le disjoncteur placé chez l'utilisateur, en série avec une charge représentée par sa résistance R_charge.

La partie métrologique 2 du compteur dispose, pour chaque phase n considérée (n pouvant être égal à 1), d'un capteur non isolé de mesure du courant de phase $I_{phn}$, typiquement une résistance de shunt $R_{shunt}$ réalisée en un alliage présentant un très faible coefficient de variation de la résistivité en fonction de la température (par exemple en manganine).

La phase en entrée de la partie métrologique 2 du compteur électrique est la référence de potentiel (0 Volt) de la partie métrologique.

Un tel capteur de mesure non isolé, associé à une chaîne de résistances R4 et R5 formant diviseur de tension recevant en entrée la tension de phase $U_{phn}$, est suffisant pour permettre les mesures métrologiques du compteur, à savoir :

- d'une part, la mesure du courant de phase $I_{phn}$ par application de la loi d'ohm selon la relation suivante :

$$V_{mes} = -R_{shunt} \times I_{phn} \quad \text{(équation 1)}$$

dans laquelle $V_{mes}$ est la différence de potentiel mesurée aux bornes de la résistance de shunt, l'entrée de la phase étant la référence de tension;

- d'autre part, la mesure de la tension de phase $U_{phn}$ selon la relation suivante :

$$V_{amont}^{phn} = U_{phn} \times \frac{R4}{(R4+R5)} = -V1 \times \frac{R4}{(R4+R5)} \quad \text{(équation 2)}$$

dans laquelle $V_{amont}^{phn}$ est égale à la mesure de la différence de potentiel entre le conducteur de neutre et la phase n coté réseau de distribution, c'est-à-dire en amont de la partie métrologique 2.

La partie métrologique 2 comporte en outre, pour chaque phase considérée, un contacteur de coupure K1 en série avec la résistance de shunt, et en aval de cette dernière, dont le pôle est équivalent à une résistance qui a une valeur très élevée (supérieure à 5 Meg), lorsque le pôle est ouvert et une valeur très faible (inférieure 500 $\mu$Ohms) lorsque le pôle est fermé.

Le dispositif de surveillance selon l'invention comporte deux résistances R1 et R2 en série formant un deuxième diviseur de tension aux bornes de l'ensemble constitué par la résistance de shunt et le contacteur de coupure K1. La présence de ce deuxième diviseur de tension permet de mesurer la différence de potentiel entre le conducteur de phase en aval du pôle du contacteur de coupure K1 et la référence de potentiel métrologique qui est ici le potentiel du conducteur de phase en amont de la partie métrologique, laquelle peut s'exprimer par la formule suivante:

$$V_{aval-amont}^{phn} = V_{pôle}^{phn} \times \frac{R1}{(R1+R2)} \quad \text{(équation 3)}$$

dans laquelle $V_{pôle}^{phn}$ est la tension aux bornes de l'ensemble série formé par la résistance de shunt et le contacteur de coupure.

Avantageusement, le dispositif de surveillance comporte également une résistance R3 qui est placée entre le conducteur de phase et le conducteur de neutre en aval du contacteur de coupure. Cette résistance R3 établit par défaut une impédance minimale en aval du pôle du contacteur.

Dans un mode de réalisation possible non limitatif de l'invention, on pourra choisir $R1 = R4 = Ra = 866$ Ohms et $R3 = R5 = R2 = Rb = 960$ KOhms.

On va maintenant expliquer comment ce dispositif de surveillance est utilisé pour détecter les différentes situations explicitées en introduction.

On s'intéresse dans un premier temps au cas de fonctionnement normal du compteur électrique, dans lequel le contacteur de coupure K1 et le disjoncteur principal K2 sont tous les deux fermés. Comme cela a été indiqué précédemment, le dispositif de surveillance équipant le compteur conformément à l'invention va également pouvoir être utilisé pour détecter une élévation anormale de la résistance de contact $R_{K1}$ (voir figure 1).

Le pôle du contacteur de coupure K1 en position fermée est équivalent à une résistance de très faible valeur ($R_{K1}$ est inférieure à 500 $\mu$Ohms), cette résistance occasionnant des pertes actives permanentes qui participent à l'élévation de température du compteur.

L'équation 3 ci-dessus peut également s'écrire sous la forme :

$$V_{aval-amont}^{phn} = -(R_{shunt} + R_{K1}) \times I_{phn} \times \frac{R1}{(R1+R2)} \quad \text{(équation 3 bis)}$$

Soit, en combinant avec l'équation 1 :

$$V^{phn}_{aval-amont} = \frac{(R_{shunt} + R_{K1})}{R_{shunt}} \times V_{mes} \times \frac{R1}{(R1 + R2)} \quad \text{(équation 3 ter)}$$

Les deux mesures $V_{mes}$ et $V^{phn}_{aval-amont}$ sont de faibles amplitudes. En effet, la sensibilité pour la voie de mesure courant est de 150 μV/A pour une résistance $R_{shunt}$ de 150 μOhms, et la sensibilité aux bornes de l'ensemble capteur-contacteur de coupure est de 0,585 μV/A si $R1$ est fixée à 866 Ohms et R2 à 960 KOhms.

Pour traiter ces deux mesures, on prévoit ainsi de les amplifier par des amplificateurs à gain programmable. On peut extraire, à partir de ces deux mesures ainsi amplifiées, une information représentative uniquement des pertes actives dans les deux résistances, par le calcul de la valeur moyenne sur une durée donnée, par exemple sur une seconde, du produit des deux mesures amplifiées, soit

$$G_1 \times G_2 \times R_{shunt} \times (R_{shunt} + R_{K1}) \times I^2_{phn}$$

où $G_1$ et $G_2$ sont les gains d'amplification appliqués respectivement sur les deux mesures.

La racine carrée de la valeur moyenne obtenue divisée par la valeur efficace de la chute de tension aux bornes de la résistance de shunt donne un coefficient C où apparaît le ratio des deux résistances :

$$\text{Soit C} = 1 + \frac{R_{K1}}{R_{shunt}}$$

En prenant les valeurs suivantes :

$R_{K1}$ = 300 μOhms et $R_{shunt}$ = 150 μOhms, ce coefficient vaut 3, et une puissance active de 2 Watts est dissipée dans le pôle du contacteur de coupure, pour un courant efficace de 82 Ampères.

Supposons à présent que la résistance du contacteur de coupure dérive de 300 μOhms à 3000 μOhms. Le coefficient C passe alors à 21, et une puissance active de 20 Watts est à présent dissipée, pour un même courant efficace de 82 Ampères, ce qui est non admissible à l'intérieur du boîtier du compteur, la puissance active dissipée de 20 Watts provoqiant une très forte élévation de température au sein du compteur.

La surveillance consiste donc à utiliser les deux mesures $V_{mes}$ et $V^{phn}_{aval-amont}$ pour vérifier que la dérive $\Delta C$ du coefficient C ci-dessus n'excède pas un certain seuil (par exemple 200%). Lorsque ce seuil est dépassé, le compteur doit commander impérativement l'ouverture du contacteur de coupure K1. Une alarme peut être en outre déclenchée, et re-transmise par le compteur électrique à un système centralisé du réseau de distribution par une communication via un concentrateur, par exemple par une communication par courants porteurs.

On s'intéresse à présent au cas où le contacteur de coupure K1 est en position ouverte :

La figure 2 illustre sous forme de schéma électrique équivalent dans le cas d'une fraude consistant à établir un court-circuit du contacteur de coupure K1.

Il suffit dans ce cas de mesurer les deux tensions $V^{phn}_{amont}$ et $V^{phn}_{aval-amont}$, et de comparer les valeurs ainsi obtenues. Une situation de fraude sur une phase n sera considérée comme détectée dans le cas où la tension $V^{phn}_{aval-amont}$ est inférieure à un seuil bas correspondant à un pourcentage X%, de l'ordre de 2% de $V^{phn}_{amont}$.

Ainsi, à titre d'exemple :

Si $V^{phn}_{amont}$ = 230 V, le seuil bas correspondant est fixé à 4,6 Vrms.

La surveillance consiste donc à utiliser les deux mesures $V^{phn}_{amont}$ et $V^{phn}_{aval-amont}$ pour vérifier que la tension $V^{phn}_{aval-amont}$ ne passe pas en deçà d'un seuil bas correspondant à un pourcentage prédéfini X% de

$V_{amont}^{phn}$. Dans le cas contraire, le compteur doit produire une alarme re-transmise par le compteur électrique à un système centralisé du réseau de distribution par une communication via un concentrateur, par exemple par une communication par courants porteurs, pour l'informer de la fraude.

La figure 3 illustre sous forme de schéma électrique équivalent à la présence d'une source d'auto production en aval du contacteur de coupure, cette source étant représentée sous la référence V2. La source d'auto production génère donc une différence de potentiel V2 entre le conducteur de phase et le conducteur de neutre en aval de la partie métrologique 2 qui diffère en amplitude et en phase de la source de puissance V1.

Il suffit là encore de mesurer les deux tensions $V_{amont}^{phn}$ et $V_{aval-amont}^{phn}$ de manière à déterminer très précisément cette différence de potentiel V2.

En effet, la tension $V_{aval-amont}^{phn}$ n'est alors dans ce cas plus nulle, mais donnée par la relation :

$$V_{aval-amont}^{phn} = \frac{R1}{(R1+R2)} \times (V2 - V1) \text{ (équation 4)}$$

de sorte que la tension V2 peut être très précisément déterminée en appliquant la relation suivante (combinaison des équations 2 et 4 ci-dessus) :

$$V2 = -\frac{(R4+R5)}{R4} V_{amont}^{phn} + \frac{(R1+R2)}{R1} V_{aval-amont}^{phn} \text{ (équation 5)}$$

Cette équation peut être simplifiée par l'équation suivante :

$$V2 = g \times \left( V_{aval-amont}^{phn} - V_{amont}^{phn} \right) \text{ (équation 6)}$$

avec $g = \frac{(Ra+Rb)}{Ra}$, dans le cas particulier avantageux où :

$R1 = R4 = Ra$ et $R5 = R2 = Rb$

Une situation de présence d'une source d'auto production sur une phase n sera considérée comme détectée dans le cas où :

- la tension V2 calculée à partir des équations 5 ou 6 ci-dessus présente une phase qui diffère de la tension V1. Dans ce cas, il suffit de prévoir des moyens de détection des passages à zéro du signal et d'en déduire la phase du signal; et où
- l'amplitude de la tension V2 calculée à partir des équations 5 ou 6 ci-dessus est supérieure à un pourcentage Y% donné de l'amplitude de V1, typiquement à 70% de V1.

La surveillance consiste donc ici à utiliser les deux mesures $V_{amont}^{phn}$ et $V_{aval-amont}^{phn}$ et vérifier si la tension V2 calculée à partir des équations 5 et 6 remplie les deux conditions précédentes en termes de phase et d'amplitude.

Dans ce cas, le compteur, par son programme interne, ne doit autoriser aucune commande de fermeture du contacteur de coupure K1.

Comme indiqué précédemment, il peut également exister une exigence supplémentaire selon laquelle un ordre de ré-enclenchement du contacteur de coupure K1 ne doit être validé que suite à une action volontaire de l'utilisateur sur le disjoncteur principal K2. Dans ce cas, avant que le compteur commande effectivement la fermeture du contacteur de coupure, il doit au préalable détecter une séquence de ré-enclenchement manuel du disjoncteur principal K2. Les mesures des deux tensions $V_{amont}^{phn}$ et $V_{aval-amont}^{phn}$ délivrées par le dispositif de surveillance vont également permettre cette détection.

En effet, dans ce cas, d'une part, les deux tensions mesurées ont même phase et même fréquence car ces deux tensions sont issues de la même source de puissance V1, et d'autre part, la tension mesurée $V^{phn}_{aval-amont}$ est une fraction de la tension mesurée $V^{phn}_{amont}$, cette fraction étant directement influencée par la valeur de la résistance interne au compteur et placée entre la phase et le neutre en aval du contacteur, par la valeur de l'impédance aval $R_{aval}$ du bloc 3, et par l'état ouvert ou fermé du disjoncteur principal K2.

Plus précisément, la tension mesurée $V^{phn}_{aval-amont}$ peut s'exprimer sous la forme :

$$V^{phn}_{aval-amont} = -\frac{R1}{R1+R2+\dfrac{R3\times R_{aval}}{R3+R_{aval}}}\times V1 \quad \text{(équation 7)}$$

soit, en remplaçant V1 par sa valeur déterminée par l'équation 2 ci-dessus :

$$V^{phn}_{aval-amont} = \frac{R1}{R1+R2+\dfrac{R3\times R_{aval}}{R3+R_{aval}}}\times\frac{(R4+R5)}{R4}\times V^{phn}_{amont} \quad \text{(équation 8)}$$

avec $R_{aval} = R_{K2} + R_{charge}$ lorsque le disjoncteur K2 est à l'état ouvert et $R_{aval} = R_{charge}$ lorsque le disjoncteur K2 est à l'état fermé.

L'ordre de grandeur de $R_{charge}$ est à comparer avec une résistance de 10 kOhms qui consomme 5,3 W sous 230 V. La résistance $R_{K2}$ offerte par le disjoncteur K2 lorsque ce dernier est ouvert fait que l'impédance aval est supérieure à 3 MOhms.

Ainsi la détection préalable du ré-enclenchement du disjoncteur K2 est basée sur la détection d'une transition entre deux valeurs relatives de $V^{phn}_{aval-amont}$ par rapport à $V^{phn}_{amont}$.

A titre d'exemple numérique, on aura :

- lorsque le disjoncteur K2 est ouvert :

$$V^{phn}_{aval-amont} = a_1 \times V^{phn}_{amont}$$

avec a1 voisin de 0,5 en prenant comme hypothèse R3 = R2 = R5.

- lorsque le disjoncteur K2 est fermé et qu'une charge minimale reste connectée en aval du disjoncteur K2 :

$$V^{phn}_{aval-amont} = a_2 \times V^{phn}_{amont}$$

avec a2 voisin de 0,9 en prenant comme hypothèse R3 = R2 = R5 et Raval = 0,1. R3

Dans un mode de réalisation préféré, une détection de transition entre les états :

Etat 1: $V^{phn}_{aval-amont} = 50\% \times V^{phn}_{amont}$ avec une tolérance de +/-10%

et

Etat 2 : $V^{phn}_{aval-amont} = 90\% \times V^{phn}_{amont}$ avec une tolérance de (-30%, +5%)

sera interprétée comme un ré enclenchement du disjoncteur principal K2 (séquence état ouvert suivi d'un état fermé).

Cette détection pourra être utilisée pour valider un ordre de ré-enclenchement du contacteur de coupure K1. La sécurisation de la fonction ré-enclenchement pourra avantageusement être obtenue par la détection de n commutations entre les états 1 et 2 durant un intervalle de temps limité qui débutera après la première détection d'une transition de l'état 1 vers l'état 2, ou d'une transition de l'état 2 vers l'état 1.

Ainsi cette détection pourra être utilisée pour valider un ordre de ré-enclenchement du contacteur de coupure K1 de façon identique par détection d'une ou de préférence de n transitions de l'état 1 vers l'état 2, ou de l'état 2 vers l'état 1 durant un intervalle de temps prédéterminé. A titre d'exemple non limitatif, le nombre de transitions peut être fixé à 3 sur un intervalle de temps de 6 secondes.

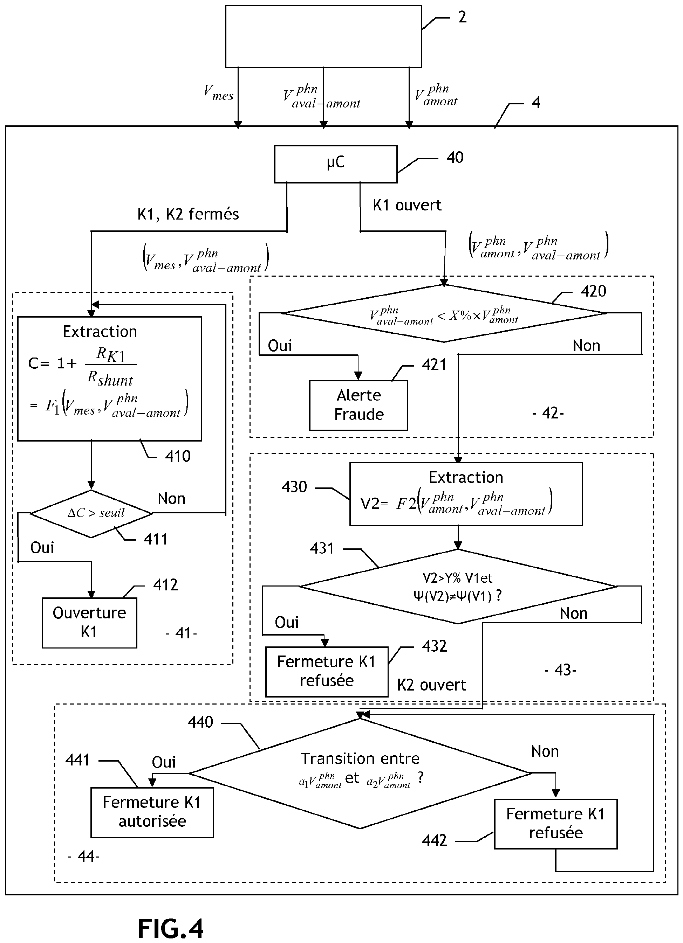

Les différentes détections décrites ci-dessus sont mises en oeuvre de préférence par des moyens numériques de traitement de signal propres au compteur qui vont être décrits en référence à la figure 4 :

Les différentes mesures $V_{mes}$, $V_{amont}^{phn}$ et $V_{aval-amont}^{phn}$ effectuées pour une phase n par la partie métrologique 2 du compteur et son dispositif de surveillance sont numérisées par un moyen d'échantillonnage (non représenté) pour être délivrées à un bloc 4 de traitement numérique des signaux. Au préalable à cette numérisation, les signaux seront de préférence amplifiés comme déjà expliqué ci-avant.

Le bloc 4 de traitement numérique comprend un processeur de signaux, typiquement un micro contrôleur 40, qui va faire appel à des routines logicielles particulières pour effectuer les différents traitements. C'est ce même microcontrôleur 40 qui gère les commandes d'ouverture et de fermeture du contacteur de coupure K1, sur demande du réseau de distribution. Le traitement de base du compteur, à savoir l'extraction de la puissance consommée (K1 et K2 fermés) à partir des mesures $V_{mes}$, $V_{amont}^{phn}$, n'est pas représenté sur la figure 4.

Sur la figure 4, la référence 41 est la routine logicielle qui met en oeuvre la détection d'une élévation anormale de la résistance du contact de coupure K1. Cette routine s'effectue périodiquement lors des phases de fonctionnement du compteur, c'est-à-dire lorsque le contacteur de coupure K1 et le disjoncteur principal K2 sont tous les deux dans l'état fermé. Comme explicité ci-dessus, cette routine 41 élabore (étape ou sous routine 410) le calcul du coefficient C qui peut s'exprimer comme une fonction F1 des mesures $V_{mes}$ et $V_{aval-amont}^{phn}$, mais aussi comme une fonction du

rapport $\dfrac{R_{K1}}{R_{shunt}}$. La routine 41 surveille alors (étape ou sous routine 411) la dérive $\Delta C$ de ce coefficient C par rapport à un seuil prédéterminé (par exemple 200%). Si ce seuil est atteint, la routine 41 commande (étape ou sous routine 412) l'ouverture du contacteur de coupure K1, le compteur pouvant, par des moyens de communication appropriés (courants porteurs en ligne ou radiofréquence), signaler ce défaut de l'organe de comptage à une unité de supervision centrale.

Les autres cas de détection sont tous réalisés lorsque le contacteur de coupure K1 a été placé au préalable dans la position ouverte :

La routine logicielle référencée 42 est celle qui est lancée en premier en vue de détecter une fraude potentielle par court-circuit du compteur. Cette routine surveille (étape ou sous routine 420) si la mesure de $V_{aval-amont}^{phn}$ passe en-deçà d'un seuil bas correspondant à un pourcentage X% de la mesure de $V_{amont}^{phn}$. Le cas échéant, une alerte à la fraude est générée (étape ou sous routine 421) et retransmise par le compteur, par des moyens de communication appropriés (courants porteurs en ligne ou radiofréquence), à une unité de supervision centrale.

Dans le cas contraire, une routine logicielle 43 est exécutée pour la détection de présence d'une éventuelle source d'autoproduction. Cette routine élabore (étape ou sous routine 430) le calcul du signal de tension V2 généré par une telle source, qui peut s'exprimer comme une fonction F2 des mesures $V_{amont}^{phn}$ et $V_{aval-amont}^{phn}$ (voir équation 5 ou 6 précitée). La routine 43 surveille alors (étape ou sous routine 431) si la phase de ce signal de tension V2 est différente de la phase de V1, et si l'amplitude de ce signal de tension V2 dépasse un pourcentage Y% donné de l'amplitude de V1, typiquement 70% de V1. Le cas échéant, toute demande de fermeture du contacteur de coupure K1 doit être refusée (étape ou sous routine 432). Une signalisation pourra être retransmise par le compteur par des moyens de communication appropriés (courants porteurs en ligne ou radiofréquence), à une unité de supervision centrale.

Dans le cas contraire, et si le dispositif de surveillance comprend la résistance R3 décrite précédemment, une routine logicielle 44 peut être exécutée pour la détection d'un ré enclenchement du disjoncteur K2. Cette routine détecte (étape ou sous routine 440) la transition de la mesure $V_{aval-amont}^{phn}$ d'une première valeur égale à a1x$V_{amont}^{phn}$ à une deuxième valeur égale à a2x$V_{amont}^{phn}$ ou inversement, et empêche toute fermeture du contacteur de coupure K1 tant que cette transition n'a pas été détectée (étape ou sous routine 442), ou analysée selon une séquence déterministe mémorisée par le compteur. Dans le cas contraire, toute demande de fermeture du contacteur de coupure K1 retransmise au compteur par d'autres moyens de communication appropriés (courants porteurs en ligne ou radiofréquence) peut être autorisée (étape ou sous routine 441).

Grâce à l'invention, il est possible, dans le cas d'un compteur électrique utilisant un capteur de courant non isolé en série avec un contacteur de coupure, d'une part de surveiller l'intégrité du pôle de puissance du contacteur de coupure, et d'autre part, de détecter jusqu'à trois situations particulières (Fraude par court-circuit, Autoproduction aval, Ré-enclenchement du disjoncteur principal) lorsque le pôle du contacteur intégré au compteur est ouvert .

Pour un compteur polyphasé muni de capteurs de courant non isolés de type shunt, les différentes mesures devront être effectuées sur chacune des phases du compteur.

Les quatre détections présentées n'engendrent qu'un surcoût minimal lié à l'ajout de trois résistances de mesure (R1, R2, R3), l'essentiel du traitement étant réalisé par le logiciel métrologique. Bien entendu, l'invention couvre également les cas où moins des quatre détections décrites précédemment seraient mises en oeuvre. En outre, l'ordre des routines présentées ci-dessus, au lieu d'être exécutées séquentiellement, pourraient être exécutées indépendamment les unes des autres, et/ou dans un ordre différent, bien que la séquence décrite présente l'avantage non négligeable d'optimiser les temps de traitement et d'éviter des calculs inutiles.

**Revendications**

1. Compteur d'énergie électrique pour la mesure d'un courant de phase $I_{phn}$ et d'une tension de phase $U_{phn}$ consommés par une installation utilisateur (3) sur au moins une phase n d'un réseau de distribution électrique (1), le compteur étant du type comportant une partie métrologique (2) dont la référence de potentiel est constituée par ladite phase n, ladite partie métrologique comprenant un capteur de courant ($R_{shunt}$) non isolé en série sur le conducteur de phase n pour permettre la mesure du courant de phase $I_{phn}$ à partir d'une mesure de la différence de potentiel $V_{mes}$ aux bornes dudit capteur un contacteur de coupure (K1) en série avec ledit capteur de courant et un dispositif de surveillance apte à délivrer une mesure $V_{aval-amont}^{phn}$ représentative de la différence de potentiel entre le conducteur de phase en aval du contacteur de coupure (K1) et le conducteur de phase en amont de la partie métrologique, **caractérisé en ce que** la partie métrologique comporte en outre un premier diviseur de tension (R4, R5) recevant en entrée ladite tension de phase $U_{phn}$ et délivrant une mesure d'une différence de potential $V_{amont}^{phn}$ entre un premier potentiel donné par le conducteur de phase et un second potentiel, **en ce que** le dispositif de surveillance comprend un deuxième diviseur de tension (R1, R2) connecté en parallèle sur l'ensemble série formé par le capteur de courant ($R_{shunt}$) et le contacteur de coupure (K1) et permettant ladite mesure $V_{aval-amont}^{phn}$, et une résistance (R3) placée entre le conducteur de phase et le second potentiel en aval du contacteur de coupure (K1), et **en ce que,** l'installation utilisateur comportant un disjoncteur principal (K2) avec une résistance $R_{K2}$ en série avec une charge avec une résistance $R_{charge}$, le compteur comporte des moyens (40, 440) pour détecter, lorsque le contacteur de coupure (K1) et le disjoncteur principal (K2) sont en position ouvertes, la transition de la mesure $V_{aval-amont}^{phn}$ entre une première valeur égale à a1x$V_{amont}^{phn}$ lorsque le disjoncteur principal (K2) est ouvert, et une deuxième valeur égale à a2x$V_{amont}^{phn}$, lorsque le disjoncteur principal (K2) est fermé, la transition de la mesure $V_{aval-amont}^{phn}$ représentative d'une transition de position du disjoncteur principal (K2) d'un état fermé à un état ouvert et d'une transition de position du disjoncteur principal (K2) d'un état ouvert à un état fermé;
**en ce que**

$$a1 = \frac{R1}{R1+R2+\frac{R3 \times R_{aval}}{R3+R_{aval}}} \times \frac{(R4+R5)}{R4} \text{, avec } R_{aval} = R_{K2} + R_{charge};$$

et **en ce que**

$$a2 = \frac{R1}{R1+R2+\frac{R3 \times R_{aval}}{R3+R_{aval}}} \times \frac{(R4+R5)}{R4}, \text{ avec } R_{aval} = R_{charge}.$$

**2.** Compteur d'énergie électrique selon la revendication 1, **caractérisé en ce qu'**il comporte des moyens (40, 441) pour autoriser une demande de fermeture du contacteur de coupure (K1) lorsque ladite transition a été détectée, et des moyens (40, 442) pour refuser une demande de fermeture du contacteur de coupure (K1) sinon.

**3.** Compteur d'énergie électrique selon l'une quelconque des revendications précédentes, **caractérisé en ce que** le second potentiel est donné par un conducteur de neutre.

**4.** Compteur d'énergie électrique selon l'une quelconque des revendications 1 ou 2, **caractérisé en ce que** le second potentiel est interne au compteur.

**5.** Compteur d'énergie électrique selon l'une quelconque des revendications précédentes, **caractérisé en ce qu'il** comporte, lorsque le contacteur de coupure (K1) est en position fermée, des moyens (40, 410) de calcul d'un coefficient (C) représentatif des pertes actives dans le contacteur de coupure (K1) et le capteur de courant ($R_{shunt}$) à partir de mesures de la différence de potentiel $V_{mes}$ aux bornes dudit capteur et de mesures $V_{aval-amont}^{phn}$ représentatives de la différence de potentiel entre le conducteur de phase en aval du contacteur de coupure (K1) et le conducteur de phase en amont de la partie métrologique, et des moyens (411) de surveillance de la dérive dudit coefficient par rapport à un seuil prédéterminé, pour détecter une élévation anormale de la résistance de contact du contacteur de coupure (K1).

**6.** Compteur d'énergie électrique selon la revendication 5, **caractérisé en ce qu'**il comporte des moyens (40, 412) pour commander l'ouverture du contacteur de coupure (KI) si la dérive dudit coefficient (C) dépasse ledit seuil prédéterminé.

**7.** Compteur d'énergie électrique selon l'une quelconque des revendications précédentes, **caractérisé en ce qu'**il comporte, lorsque le contacteur de coupure (K1) est en position ouverte, des moyens (40, 420) de surveillance pour surveiller si la mesure $V_{aval-amont}^{phn}$ passe en- deçà d'un seuil bas correspondant à un pourcentage de la mesure $V_{amont}^{phn}$, et le cas échéant, des moyens (40, 421) pour générer une alerte à la fraude.

**8.** Compteur d'énergie électrique selon l'une quelconque des revendications précédentes, **caractérisé en ce qu'**il comporte, lorsque le contacteur de coupure (K1) est en position ouverte, des moyens (40, 430) de calcul d'un signal de tension (V2) représentatif d'une source d'auto production an aval du contacteur de coupure (K1) à partir des mesures $V_{amont}^{phn}$ et $V_{aval-amont}^{phn}$, des moyens de surveillance (40, 431) pour surveiller si la phase dudit signal de tension (V2) est différente de la phase de V1, et si l'amplitude dudit signal de tension (V2) dépasse un pourcentage donné de l'amplitude du signal d'entrée du réseau de distribution, typiquement 70% de V1, et, le cas échéant, des moyens (40, 432) pour refuser une demande de fermeture du contacteur de coupure (K1).

**Patentansprüche**

**1.** Stromzähler zur Messung eines Phasenstroms $I_{phn}$ und einer Phasenspannung $U_{phn}$, die von einer Verbraucheranlage (3) verbraucht werden, auf wenigstens einer Phase n eines Stromversorgungsnetzes (1), wobei der Zähler von dem Typ ist, der einen messtechnischen Teil (2) aufweist, dessen Bezugspotential von der Phase n gebildet wird, wobei der messtechnische Teil einen nicht isolierten Stromsensor ($R_{shunt}$), der mit dem Phasenleiter n in Reihe geschaltet ist, um die Messung des Phasenstroms $I_{phn}$ ausgehend von einer Messung der Potentialdifferenz $V_{mes}$ an den Klemmen des Sensors zu ermöglichen, ein Sperrschütz (K1), das mit dem Stromsensor in Reihe geschaltet ist, und eine Überwachungsvorrichtung, die geeignet ist, einen Messwert $V_{aval-amont}^{phn}$ zu liefern, der für die Potentialdifferenz zwischen dem Phasenleiter nach dem Sperrschütz (K1) und dem Phasenleiter vor dem messtechnischen Teil repräsentativ ist, umfasst, **dadurch gekennzeichnet, dass** der messtechnische Teil außerdem einen ersten Spannungsteiler (R4, R5) umfasst, der am Eingang die Phasenspannung $U_{phn}$ aufnimmt und einen Messwert einer Potentialdifferenz $V_{amont}^{phn}$ zwischen einem ersten Potential, das durch den Phasenleiter gegeben ist, und einem zweiten Potential liefert, dadurch, dass die Überwachungsvorrichtung einen zweiten Spannungsteiler (R1, R2), der zu der Reihenanordnung parallelgeschaltet ist, die von dem Stromsensor ($R_{shunt}$) und dem Sperrschützt (K1) gebildet wird, und die Messung von $V_{aval-amont}^{phn}$ ermöglicht, und einen Widerstand (R3), der zwischen dem Phasenleiter und dem zweiten Potential nach dem Sperrschütz (K1) angeordnet ist, umfasst, und dadurch, dass, wenn die Verbraucheranlage einen Hauptschutzschalter (K2) mit einem Widerstand $R_{K2}$, der mit einer Last mit einem Widerstand $R_{charge}$ in Reihe geschaltet ist, aufweist, der Zähler Mittel (40, 440) aufweist, um, wenn sich das Sperrschütz (K1) und der Hauptschutzschalter (K2) in geöffneten Positionen befinden, den Übergang des Messwertes $V_{aval-amont}^{phn}$ zwischen einem ersten Wert, der gleich $a1 \times V_{amont}^{phn}$ ist, wenn der Hauptschutzschalter (K2) geöffnet ist, und einem zweiten Wert, der gleich $a2 \times V_{amont}^{phn}$ ist, wenn der Hauptschutzschalter (K2) geschlossen ist, zu erkennen, wobei der Übergang des Messwertes $V_{aval-amont}^{phn}$ für einen Übergang der Position des Hauptschutzschalters (K2) von einem geschlossenen Zustand zu einem geöffneten Zustand und für einen Übergang der Position des Hauptschutzschalters (K2) von einem geöffneten Zustand zu einem geschlossenen Zustand repräsentativ ist;

dadurch, dass $a1 \;=\; \dfrac{R1}{R1+R2+\dfrac{R3 \times R_{aval}}{R3+R_{aval}}} \times \dfrac{(R4+R5)}{R4}$ ist, mit $R_{aval} = R_{K2} + R_{charge}$;

und dadurch, dass $a2 \;=\; \dfrac{R1}{R1+R2+\dfrac{R3 \times R_{aval}}{R3+R_{aval}}} \times \dfrac{(R4+R5)}{R4}$ ist, mit $R_{aval} = R_{charge}$.

2. Stromzähler nach Anspruch 1, **dadurch gekennzeichnet, dass** er Mittel (40, 441) zum Zulassen eines Befehls zum Schließen des Sperrschützes (K1), wenn der Übergang erkannt worden ist, und Mittel (40, 442) zum Zurückweisen eines Befehls zum Schließen des Sperrschützes (K1), wenn das nicht der Fall ist, aufweist.

3. Stromzähler nach einem der vorhergehenden Ansprüche, **dadurch gekennzeichnet, dass** das zweite Potential durch einen Neutralleiter gegeben ist.

4. Stromzähler nach einem der Ansprüche 1 oder 2, **dadurch gekennzeichnet, dass** das zweite Potential ein internes Potential des Zählers ist.

5. Stromzähler nach einem der vorhergehenden Ansprüche, **dadurch gekennzeichnet, dass** er, wenn sich das Sperrschütz (K1) in der geschlossenen Position befindet, Mittel (40, 410) zur Berechnung eines Koeffizienten (C), der für die aktiven Verluste in dem Sperrschütz (K1) und dem Stromsensor ($R_{shunt}$) repräsentativ ist, aus Messungen der Potentialdifferenz $V_{mes}$ an den Klemmen des Sensors und Messwerten $V_{aval-amont}^{phn}$, die für die Potentialdifferenz zwischen dem Phasenleiter nach dem Sperrschütz (K1) und dem Phasenleiter vor dem messtechnischen Teil repräsentativ sind, und Mittel (411) zur Überwachung der Drift dieses Koeffizienten bezüglich eines vorbestimmten Schwellenwertes, um eine anormale Erhöhung des Kontaktwiderstandes des Sperrschützes (K1) zu erkennen, aufweist.

6. Stromzähler nach Anspruch 5, **dadurch gekennzeichnet, dass** er Mittel (40, 412) zum Steuern der Öffnung des Sperrschützes (K1), falls die Drift des Koeffizienten (C) den vorbestimmten Schwellenwert überschreitet, aufweist.

7. Stromzähler nach einem der vorhergehenden Ansprüche, **dadurch gekennzeichnet, dass** er, wenn sich das Sperrschütz (K1) in der geöffneten Position befindet, Mittel (40, 420) zur Überwachung aufweist, um zu überwachen, ob der Messwert $V_{aval-amont}^{phn}$ einen unteren Schwellenwert unterschreitet, der einem prozentualen Teil des Messwertes

$V_{amont}^{phn}$ und gegebenenfalls Mittel (40, 421), um einen Betrugsalarm zu erzeugen.

8.  Stromzähler nach einem der vorhergehenden Ansprüche, **dadurch gekennzeichnet, dass** er, wenn sich das Sperrschütz (K1) in der geöffneten Position befindet, Mittel (40, 430) zur Berechnung eines Spannungssignals (V2), das für eine dem Sperrschütz (K1) nachgeschaltete Quelle der Eigenerzeugung repräsentativ ist, aus den Messwerten $V_{amont}^{phn}$ und $V_{aval-amont}^{phn}$, Überwachungsmittel (40, 431), um zu überwachen, ob die Phase des Spannungssignals (V2) von der Phase von V1 verschieden ist und ob die Amplitude des Spannungssignals (V2) einen gegebenen prozentualen Teil der Amplitude des Eingangssignals des Versorgungsnetzes, typischerweise 70 % von V1, überschreitet, und gegebenenfalls Mittel (40, 432), um einen Befehl zum Schließen des Sperrschützes (K1) zurückzuweisen, aufweist.

## Claims

1.  Electricity meter for measuring a current of phase $I_{phn}$ and a voltage of phase $U_{phn}$ that are consumed by a user installation (3) on at least one phase n of an electrical distribution network (1), the meter being of the type comprising a metrological part (2), the potential reference of which is constituted by said phase n, said metrological part comprising an uninsulated current sensor ($R_{shunt}$) in series on the phase conductor n to allow measurement of the phase current $I_{phn}$ on the basis of a measurement of the potential difference $V_{mes}$ at the terminals of said sensor, a break contactor (K1) in series with said current sensor and a monitoring device capable of delivering a measurement $V_{aval-amont}^{phn}$ representative of the potential difference between the phase conductor downstream of the break contactor (K1) and the phase conductor upstream of the metrological part,
    **characterized in that** the metrological part moreover comprises a first voltage divider (R4, R5) receiving, at the input, said phase voltage $U_{phn}$ and delivering a measurement of a potential difference $V_{amont}^{phn}$ between a first potential provided by the phase conductor and a second potential, **in that** the monitoring device comprises a second voltage divider (R1, R2) connected in parallel on the series assembly formed by the current sensor ($R_{shunt}$) and the break contactor (K1) and allowing said measurement $V_{aval-amont}^{phn}$, and a resistor (R3) situated between the phase conductor and the second potential downstream of the break contactor (K1), and **in that**, the user installation comprising a main circuit breaker (K2) with a resistor $R_{K2}$ in series with a load having a resistance $R_{charge}$, the meter comprises means (40, 440) for detecting, when the break contactor (K1) and the main circuit breaker (K2) are in open positions, the transition of the measurement $V_{aval-amont}^{phn}$ between a first value equal to $a1 \times V_{amont}^{phn}$ when the main circuit breaker (K2) is open and a second value equal to $a2 \times V_{amont}^{phn}$ when the main circuit breaker (K2) is closed, the transition of the measurement $V_{aval-amont}^{phn}$ representative of a positional transition of the main circuit breaker (K2) from a closed state to an open state and of a positional transition of the main circuit breaker (K2) from an open state to a closed state;
    **in that**

$$a1 = \frac{R1}{R1+R2+\frac{R3 \times R_{aval}}{R3+R_{aval}}} \times \frac{(R4+R5)}{R4}, \text{ where } R_{aval} = R_{K2} + R_{charge};$$

and **in that**

$$a2 = \frac{R1}{R1+R2+\frac{R3 \times R_{aval}}{R3+R_{aval}}} \times \frac{(R4+R5)}{R4}, \text{ where } R_{aval} = R_{charge}.$$

2.  Electricity meter according to Claim 1, **characterized in that** it comprises means (40, 441) for authorizing a request to close the break contactor (K1) when said transition has been detected and means (40, 442) for denying a request to close the break contactor (K1) otherwise.

3. Electricity meter according to either of the preceding claims, **characterized in that** the second potential is provided by a neutral conductor.

4. Electricity meter according to either of Claims 1 and 2, **characterized in that** the second potential is internal to the meter.

5. Electricity meter according to any one of the preceding claims, **characterized in that** it comprises, when the break contactor (K1) is in a closed position, means (40, 410) for computing a coefficient (C) representative of the active losses in the break contactor (K1) and the current sensor ($R_{shunt}$) on the basis of measurements of the potential difference $V_{mes}$ of the terminals of said sensor and of measurements $V_{aval-amont}^{phn}$ representative of the potential difference between the phase conductor downstream of the break contactor (K1) and the phase conductor upstream of the metrological part, and means (411) for monitoring the drift in said coefficient in relation to a predetermined threshold, in order to detect an abnormal increase in the contact resistance of the break contactor (K1).

6. Electricity meter according to Claim 5, **characterized in that** it comprises means (40, 412) for controlling the opening of the break contactor (K1) if the drift in said coefficient (C) exceeds said predetermined threshold.

7. Electricity meter according to any one of the preceding claims, **characterized in that** it comprises, when the break contactor (K1) is in an open position, monitoring means (40, 420) for monitoring whether the measurement $V_{aval-amont}^{phn}$ drops below a low threshold corresponding to a percentage of the measurement $V_{amont}^{phn}$ and, if need be, means (40, 421) for generating a fraud alert.

8. Electricity meter according to any one of the preceding claims, **characterized in that** it comprises, when the break contactor (K1) is in an open position, means (40, 430) for computing a voltage signal (V2) representative of a self-production source downstream of the break contactor (K1) on the basis of the measurements $V_{amont}^{phn}$ and $V_{aval-amont}^{phn}$ , monitoring means (40, 431) for monitoring whether the phase of said voltage signal (V2) is different from the phase of V1, and whether the amplitude of said voltage signal (V2) exceeds a given percentage of the amplitude of the input signal of the distribution network, typically 70% of V1, and, if need be, means (40, 432) for denying a request to close the break contactor (K1).

**FIG.1**

**FIG.2**

**FIG.3**

**FIG.4**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- GB 2281401 A
- US 20080204953 A
- GB 2313201 A